# EUROPÄISCHE PATENTANMELDUNG

(11) **EP 2 320 479 A1**
(43) Veröffentlichungstag der Anmeldung: **11.05.2011**
(21) Anmeldenummer: 09175021.6
(22) Anmeldetag: 04.11.2009
(51) Int. Cl.: H01L 31/048, B32B 17/10, H01L 31/0216

(54) **Randversiegelung von Photovoltaik-Modulen**

(71) Anmelder: Sika Technology AG, 6340 Baar (CH)
(72) Erfinder: Meier, Heinz, 8032, Zuerich (CH); Rohrer, Hans, 6072, Sachseln (CH); Keiser, Stefan, 6103, Schwarzenberg (CH); Lussi, Josef, 3920, Zermatt (CH); Blank, Norman, 8803, Rüschlikon (CH)
(74) Vertreter: Sika Patent Attorneys

(57) **Zusammenfassung**

Die vorliegende Erfindung betrifft ein Verfahren zur Randversiegelung von Photovoltaik-Modulen umfassend die Schritte
i) Bereitstellen eines Photovoltaik-Moduls 12 durch Anbringen mindestens eines Photovoltaik-Laminats 1 auf einen Träger 8;
ii) Behandeln des in Schritt i) hergestellten Photovoltaik-Moduls entlang des Randbereichs des Photovoltaik-Laminats mit einer Plasmavorbehandlung oder mit Beflammung mittels Gasflamme, sodass sowohl der Randbereich des Photovoltaik-Laminats als auch, zumindest teilweise, der Träger von der Plasmavorbehandlung bzw. von der Beflammung erfasst werden;
iii) Applikation einer Dichtmasse 9 zumindest teilweise auf die vorbehandelte Stelle, wobei die Dichtmasse eine Siliconzusammensetzung oder eine Zusammensetzung auf der Basis von silanterminierten Poly(meth)acrylaten ist.

## Beschreibung

### Technisches Gebiet

Die Erfindung betrifft das Gebiet der Randversiegelung von Photovoltaik-Modulen.

### Stand der Technik

Die Randversiegelung von Photovoltaik-Modulen ist bekannt und dient dem Schutz der Klebeschichten innerhalb des Photovoltaik-Laminats sowie der Klebeschicht zwischen Photovoltaik-Laminat und Träger. Zur Randversiegelung werden dabei Dichtmassen auf Polyamid-Basis eingesetzt.

Dichtmassen auf Polyamid-Basis zeigen nur eine eingeschränkte Haftung sowohl auf Trägermaterialien, insbesondere auf Dachbahnen, als auch auf Oberschichten von Photovoltaik-Laminaten, beispielsweise aus ETFE. Durch eine unsaubere Applikation, durch mechanische Beanspruchung beim Verlegen des Photovoltaik-Moduls oder in der Einsatzphase unter Witterungseinfluss kann sich die Randversiegelung zumindest partiell von der Kante des Photovoltaik-Laminats lösen. Wasser, insbesondere Regenwasser, kann dadurch direkt an die Kante des Photovoltaik-Laminats gelangen und längerfristig entweder die Klebschicht zwischen Dachbahn und dem Photovoltaik-Laminat schädigen oder aber zu Delaminationen innerhalb des mehrschichtig aufgebauten Photovoltaik-Laminats führen.

### Darstellung der Erfindung

Die Aufgabe der vorliegenden Erfindung ist es daher, ein Verfahren zur Randversiegelung von Photovoltaik-Modulen bereitzustellen, welches die Nachteile des Standes der Technik überwindet und zu Photovoltaik-Modulen führt, welche sicher und permanent abgedichtet sind. Überraschenderweise wurde gefunden, dass das Verfahren gemäss Anspruch 1 diese Aufgabe löst.

Durch die Anwendung des erfindungsgemässen Verfahrens ist es möglich, Siliconzusammensetzungen oder Zusammensetzungen auf Basis von silanterminierten Poly(meth)acrylaten für die Randversiegelung von Photovoltaik-Modulen zu verwenden, obwohl derartige Zusammensetzungen bekanntermassen schlechte Haftungsresultate auf Untergründen, wie sie zur Herstellung von Photovoltaik-Modulen verwendet werden, aufweisen.

Weiterhin erlaubt der Einsatz des erfindungsgemässen Verfahrens, insbesondere beim Einsatz bevorzugter zweikomponentiger Dichtmassen, die Randversiegelung von Photovoltaik-Modulen in sehr kurzen Taktzeiten.

Ein weiterer bedeutender Vorteil des erfindungsgemässen Verfahrens bzw. des erfindungsgemässen Photovoltaik-Moduls ist die besondere UV-Stabilität der eingesetzten Dichtmassen, welche eine sichere Abdichtung des Photovoltaik-Moduls während der gesamtem garantierten Lebensdauer des Photovoltaik-Laminats erlaubt.

Weitere Aspekte der Erfindung sind Gegenstand weiterer unabhängiger Ansprüche. Besonders bevorzugte Ausführungsformen der Erfindung sind Gegenstand der abhängigen Ansprüche.

### Kurze Beschreibung der Zeichnungen

Anhand der Zeichnungen werden Ausführungsbeispiele der Erfindung näher erläutert. Gleiche Elemente sind in den verschiedenen Figuren mit den gleichen Bezugszeichen versehen. Selbstverständlich ist die Erfindung nicht auf gezeigte und beschriebene Ausführungsbeispiele beschränkt.

Es zeigen:
- Figur 1: eine schematische Darstellung (Querschnitt) eines Photovoltaik- Laminats;
- Figur 2: eine schematische Darstellung (Querschnitt) eines Photovoltaik- Moduls bestehend aus Photovoltaik-Laminat und Träger bei der Plasmavorbehandlung;
- Figur 3: eine schematische Darstellung (Querschnitt) eines Photovoltaik- Moduls mit Randversiegelung;
- Figur 4: eine schematische Darstellung (Querschnitt) eines Photovoltaik- Moduls mit Randversiegelung;
- Figur 5: eine schematische Darstellung (Querschnitt) eines Photovoltaik- Moduls mit Randversiegelung;
- Figur 6: eine schematische Darstellung (Querschnitt) eines Photovoltaik- Moduls mit verlängerter Oberschicht und Randversiegelung;
- Figur 7: eine schematische Darstellung (Querschnitt) eines Photovoltaik- Moduls mit verlängerter Oberschicht und Randversiegelung im Bördelfalz;
- Figur 8: eine schematische Darstellung (Ansicht von oben) eines Bereichs eines Photovoltaik-Moduls;
- Figur 9: eine schematische Darstellung (Ansicht von oben) eines Photovoltaik-Moduls.

In den Figuren sind nur die für das unmittelbare Verständnis der Erfindung wesentlichen Elemente gezeigt.

### Wege zur Ausführung der Erfindung

Die vorliegende Erfindung betrifft ein Verfahren zur Randversiegelung von Photovoltaik-Modulen umfassend die Schritte
i) Bereitstellen eines Photovoltaik-Moduls 12 durch Anbringen mindestens eines Photovoltaik-Laminats 1 auf einen Träger 8;
ii) Vorbehandeln des in Schritt i) hergestellten Photovoltaik-Moduls entlang des Randbereichs des Photovoltaik-Laminats mit einer Plasmavorbehandlung oder mit Beflammung mittels Gasflamme, sodass sowohl der Randbereich des Photovoltaik-Laminats als auch, zumindest teilweise, der Träger von der Plasmavorbehandlung bzw. von der Beflammung erfasst werden;
iii) Applikation einer Dichtmasse 9 zumindest teilweise auf die vorbehandelte Stelle, wobei die Dichtmasse eine Siliconzusammensetzung oder eine Zusammensetzung auf der Basis von silanterminierten Poly(meth)acrylaten ist.

Im vorliegenden Dokument bezeichnet der Begriff "Photovoltaik-Laminat" eine oder mehrere photovoltaische Zellen, d.h. elektrische Bauelemente zur Umwandlung von Strahlungsenergie, insbesondere Sonnenlicht, in elektrische Energie, welche mindestens einseitig, vollflächig mit einer Kunststoffschicht bedeckt sind. In der Regel weist ein Photovoltaik-Laminat beidseitig, vollflächig eine oder mehrere Schichten auf.

Der Begriff "Photovoltaik-Modul" bezeichnet im vorliegenden Dokument eine Anordnung eines oder mehrerer Photovoltaik-Laminaten, welche auf oder an einem beliebigen Träger angeordnet sind und welche zur Gewinnung von Solarstrom eingesetzt werden.

Mit "Poly" beginnende Substanznamen wie beispielsweise Polyol bezeichnen im vorliegenden Dokument Substanzen, die formal zwei oder mehr der in ihrem Namen vorkommenden funktionellen Gruppen pro Molekül enthalten.

Der Begriff "Polymer" umfasst im vorliegenden Dokument einerseits ein Kollektiv von chemisch einheitlichen, sich aber in Bezug auf Polymerisationsgrad, Molmasse und Kettenlänge unterscheidenden Makromolekülen, das durch eine Polyreaktion (Polymerisation, Polyaddition, Polykondensation) hergestellt wurde. Der Begriff umfasst andererseits auch Derivate eines solchen Kollektivs von Makromolekülen aus Polyreaktionen, Verbindungen also, die durch Umsetzungen, wie beispielsweise Additionen oder Substitutionen, von funktionellen Gruppen an vorgegebenen Makromolekülen erhalten wurden und die chemisch einheitlich oder chemisch uneinheitlich sein können. Der Begriff umfasst weiterhin auch so genannte Prepolymere, das heisst reaktive oligomere Voraddukte, deren funktionelle Gruppen am Aufbau von Makromolekülen beteiligt sind.

Das Photovoltaik-Laminat weist eine oder mehrere photovoltaische Zellen auf. Der Aufbau und die Struktur derartiger Zellen sind dem Fachmann bestens bekannt. In einem bevorzugten Photovoltaik-Laminat ist die Schicht mit der oder den photovoltaischen Zellen beidseitig, vollflächig mit mindestens einer weiteren Schicht versehen. Diese weiteren Schichten dienen hauptsächlich dem Schutz der Zellen vor mechanischen Einwirkungen oder schädigenden Umwelteinflüssen.

Vorzugsweise weist das Photovoltaik-Laminat beidseitig der photovoltaischen Zellen mehrere Kunststoffschichten auf. Diese Kunststoffschichten können dabei aus demselben oder aus unterschiedlichen Materialien sein. Weiterhin können die Schichten mit unterschiedlichen Schichtdicken ausgebildet sein.

Insbesondere weist das Photovoltaik-Laminat als oberste Kunststoffschicht gegen aussen (Oberschicht), d.h. jene Kunststoffschicht, welche direkt den Umwelteinflüssen ausgesetzt ist, eine Schicht aus einem zumindest teilweise halogenierten Polymer auf. Vorzugsweise handelt es sich beim halogenierten Polymer um ein zumindest teilweise fluoriertes Polymer oder um ein Copolymer von fluorierten mit nicht fluorierten Monomeren. Insbesondere handelt es sich dabei um Polytetrafluorethylen (PTFE) oder Ethylen-Tetrafluorethylen (ETFE), bevorzugt um ETFE. Diese Materialien eignen sich besonders für die Oberschicht, da sie einerseits eine hohe chemische Beständigkeit aufweisen, wodurch sie besonders resistent gegenüber Umwelteinflüssen sind, und andererseits eine hohe Licht- und UV-Durchlässigkeit aufweisen.

Neben der beschriebenen Oberschicht bestehen weitere Kunststoffschichten des Photovoltaik-Laminats beispielsweise aus Polyolefinen, Polyethern, Polyestern, Polycarbonaten, Poly(meth)acrylaten oder anderen, gegebenenfalls substituierten, Polykohlenwasserstoffen. Bevorzugte Materialien sind Poylethylen, Polypropylen, Polyethylenterephthalat (PET) und Ethylvinylacetat (EVA). Diese weiteren Kunststoffschichten können dabei unterschiedlich ausgebildet sein und auch unterschiedliche Funktionen aufweisen. Weiterhin weist das Photovoltaik-Laminat typischerweise eine weitere Schicht auf, welche als Substrat für die photovoltaische Beschichtung dient und sich somit direkt hinter der Schicht mit den photovoltaischen Zellen befindet. Diese Schicht kann ebenfalls aus einem Kunststoff bestehen oder aus Metall. Handelt es sich bei dieser Schicht um eine Metallschicht, so besteht diese insbesondere aus rostfreiem Stahl.

Das gesamte Photovoltaik-Laminat weist eine Schichtdicke im Bereich von 0.5 bis 5 mm, insbesondere von 2 bis 3 mm auf, wobei diese Schichtdicke auf die unterschiedlichen Schichten des Photovoltaik-Laminats aufgeteilt ist.

Besonders bevorzugt handelt es sich beim Photovoltaik-Laminat um ein flexibles Photovoltaik-Laminat. Dieses weist den Vorteil auf, dass auch auf unebenen Flächen angebracht oder für die Anwendung bis zu einem gewissen Grad verformt werden kann.

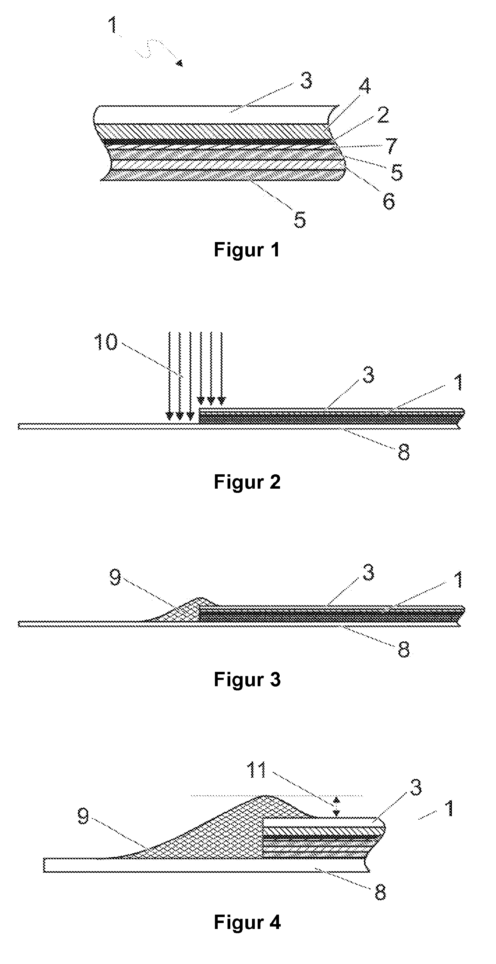

Figur 1 zeigt beispielhaft einen schematischen Aufbau eines Photovoltaik-Laminats 1, bestehend folgenden Schichten von oben nach unten bzw. von aussen nach innen: Oberschicht 3 aus ETFE; Schicht aus EVA 4; Schicht umfassend Photovoltaische Zellen 2; Substrat für die photovoltaische Beschichtung 7; Schicht aus PE 5; Schicht aus PET 6 und Schicht aus PE 5.

Beim Träger, an welchem das Photovoltaik-Laminat angebracht wird, kann es sich um einen beliebigen Träger handeln. Insbesondere handelt es sich jedoch um einen flexiblen Träger, da dieser, vor allem im Zusammenhang mit einem flexiblen Photovoltaik-Laminat, die bereits beschriebenen Vorteile aufweist. Bevorzugt handelt es sich beim Träger um eine Membran, insbesondere um eine Kunststoff-Dichtungsbahn. Derartige Kunststoff-Dichtungsbahnen werden typischerweise zur äusseren Abdichtung von Dach- und Fassadenkonstruktionen eingesetzt und zeichnen sich durch gute Abdichtungseigenschaften auch bei hohem Wasserdruck sowie guten Werten in Weiterreiss- und Perforationsversuchen aus, was besonders bei mechanischen Belastungen auf Baustellen vorteilhaft ist.

Der Vorteil eines Photovoltaik-Moduls bestehend aus einem flexiblem Photovoltaik-Laminat und einer Kunststoff-Dichtungsbahn als Träger ist, dass dieser wie eine herkömmliche Kunststoff-Dichtungsbahn, beispielsweise wie eine Dachfolie, verlegt werden kann. Ein weiterer Vorteil liegt darin, dass ein derartiges Photovoltaik-Modul auch an unebenen Flächen, beispielsweise auf einem Bogendach, formgenau verlegt werden kann.

Vorzugsweise handelt es sich beim Träger um einen Polyolefin-Träger oder um einen Polyvinylchlorid-Träger. Diese beiden Materialien sind in der Fertigung von Kunststoff-Dichtungsbahnen weit verbreitet. Meist bevorzugte Trägermaterialien sind Polyethylen (PE) wie Polyethylen mit hoher Dichte (HDPE), Polyethylen mit mittlerer Dichte (MDPE) und Polyethylen mit niedriger Dichte (LDPE), Polyethylenterephthalat (PET), Polystyrol (PS), Polyvinylchlorid (PVC), Polyamide (PA), EVA, chlorsulfoniertes Polyethylen, thermoplastische Elastomere auf Olefinbasis (TPE-O, TPO), Ethylen-Propylen-Dien-Kautschuk (EPDM), Polyisobutylen (PIB) sowie Mischungen davon.

Das Photovoltaik-Laminat kann auf beliebige Art auf dem Träger befestigt sein. Insbesondere wird das Photovoltaik-Laminat auf den Träger geklebt. Bevorzugt erfolgt die Verklebung des Photovoltaik-Laminats auf dem Träger mittels Heiss- oder Warmschmelzklebstoff (Hotmelt oder Warmmelt). Insbesondere wird das Photovoltaik-Laminat mit einem Heissschmelzklebstoff auf Basis von Polyurethan auf den Träger geklebt.

Bei Bedarf kann zwischen dem Photovoltaik-Laminat und dem Träger eine Ausgleichsschicht angeordnet sein, welche Spannungen entstehend durch Verschieben des Photovoltaik-Laminats gegenüber dem Träger ausgleicht und somit ein Ablösen des Photovoltaik-Laminats vom Träger verhindert. Derartige Spannungen können durch mechanische Belastungen entstehen oder sind bedingt durch Verschiebungen aufgrund unterschiedlicher linearer Wärmeausdehnungskoeffizienten von Photovoltaik-Laminat und Träger. Letzteres ist insbesondere bei intensiver Sonneneinstrahlung oder bei grossen Temperaturschwankungen der Fall.

Bei der Ausgleichsschicht handelt es sich beispielsweise um eine geschäumte Schicht aus einem thermoplastischen Material wie einem thermoplastischen Elastomer. Bevorzugt handelt es sich bei der Ausgleichsschicht um eine Schicht aus einem geschäumten, elastischen Material.

Weiterhin ist es möglich, dass anstelle einer separaten Ausgleichsschicht das Photovoltaik-Laminat mit einem geschäumten Klebstoff auf den Träger verklebt wird.

Das Vorbehandeln des in Schritt i) des erfindungsgemässen Verfahrens hergestellten Photovoltaik-Moduls erfolgt mit einer Plasmavorbehandlung oder mit Beflammung mittels Gasflamme.

Bei der Plasmavorbehandlung wird das zuvor hergestellte Photovoltaik-Modul entlang des Randbereichs des Photovoltaik-Laminats mit einem Plasma behandelt. Als Gas, welches hierbei im Plasmazustand vorliegt, können verschiedene Gase oder Gasgemische eingesetzt werden. Ebenso kann die Energie, welche das Gas zum Übergang in den Plasmazustand benötigt, auf unterschiedliche Art zugeführt werden.

Weiterhin ist es auch möglich und kann sogar von Vorteil sein, dem Gas Additive, beispielsweise Silane, zuzusetzen, um eine besonderes haftfreundliche Vorbehandlung zu erreichen.

Bevorzugt handelt es sich der Plasmavorbehandlung um eine Luftplasmabehandlung bei Atmosphärendruck.

Figur 2 zeigt beispielhaft den schematischen Aufbau eines Photovoltaik-Moduls bestehend aus einem Photovoltaik-Laminat 1 mit der Oberschicht aus ETFE 3, welcher auf einer Kunststoff-Dichtungsbahn verklebt ist. Die Pfeile welche auf den Randbereich des Photovoltaik-Laminats gerichtet sind, stellen einen Plasma-Strahl 10 der Plasmavorbehandlung dar, welcher sowohl diesen Randbereich als auch, zumindest teilweise, die Kunststoff-Dichtungsbahn erfasst.

Bei der Beflammung mittels Gasflamme wird das zuvor hergestellte Photovoltaik-Modul entlang des Randbereichs des Photovoltaik-Laminats für kurze Zeit der direkten Einwirkung einer Gasflamme ausgesetzt. Die Dauer der Beflammung muss dabei so gewählt sein, dass das Photovoltaik-Modul oder der Träger dabei nicht beschädigt werden.

Als Gas für die Beflammung eignen sich beispielsweise Propan oder Butan, wobei die Gasflamme insbesondere mit Sauerstoffüberschuss betrieben wird, um die Oberfläche optimal vorzubehandeln.

Bevorzugt wird das Photovoltaik-Modul mit Plasma vorbehandelt. Gegenüber der Beflammung weist die Plasmavorbehandlung den Vorteil auf, dass bessere Haftungsresultate erzielt werden und dass die Gefahr der Beschädigung des Photovoltaik-Moduls oder des Trägers durch die Gasflamme geringer ist.

Um eine optimale Haftung der Dichtmasse auf dem Photovoltaik-Modul zu erreichen, ist es vorteilhaft, die Dichtmasse innerhalb von 4 Wochen, insbesondere innerhalb von 2 Wochen, bevorzugt unmittelbar, nach der Plasmavorbehandlung oder nach der Beflammung auf die Stelle der Vorbehandlung aufzutragen.

Weiterhin ist es von Bedeutung für die vorliegende Erfindung, dass die gesamte Stelle, an welcher die Dichtmasse appliziert werden soll, von der Plasmavorbehandlung oder von der Beflammung erfasst wird.

Die Dichtmasse kann von Hand oder in einem automatisierten Prozess mittels Roboter auf das Photovoltaik-Modul aufgetragen werden. Insbesondere wird die Dichtmasse maschinell aufgetragen.

Die Dichtmasse kann in unterschiedlicher Form aufgetragen werden, sodass Abdichtungen mit unterschiedlichen Querschnittsformen entstehen.

Die Figuren 3 bis 5 zeigen beispielhaft zwei unterschiedlich applizierte Dichtmassen anhand ihrer Querschnittsformen. Bevorzugt wird dabei die Dichtmasse 9 so aufgetragen, dass sowohl der Randbereich des Photovoltaik-Laminats 1 bzw. der Oberschicht 3 des Photovoltaik-Laminats als auch ein Teil des Trägers 8 von ihr erfasst werden. Insbesondere wird die Dichtmasse so aufgetragen, dass die Höhe 11, um welche die Dichtmasse das Photovoltaik-Laminat überragt, bei optimaler Abdichtung möglichst gering ist. Insbesondere ist diese Höhe 11 nicht grösser als 3 mm, bevorzugt nicht grösser als 1 mm. Überragt die Dichtmasse das Photovoltaik-Laminat zu sehr, kann das verschiedene Nachteile aufweisen. Beispielsweise wird in diesem Fall auch bei horizontal oder leicht geneigt angeordneten Photovoltaik-Modulen das Abfliessen von Regenwasser verhindert, sodass stehendes Wasser auf dem Photovoltaik-Modul entsteht. Bei begehbaren Photovoltaik-Modulen führt dies zu einer erhöhten Rutschgefahr. Ein weiterer Nachteil der zu hoch ragenden Dichtmasse auf begehbaren Systemen ist, dass die Dichtmasse in diesem Fall leichter beschädigt wird.

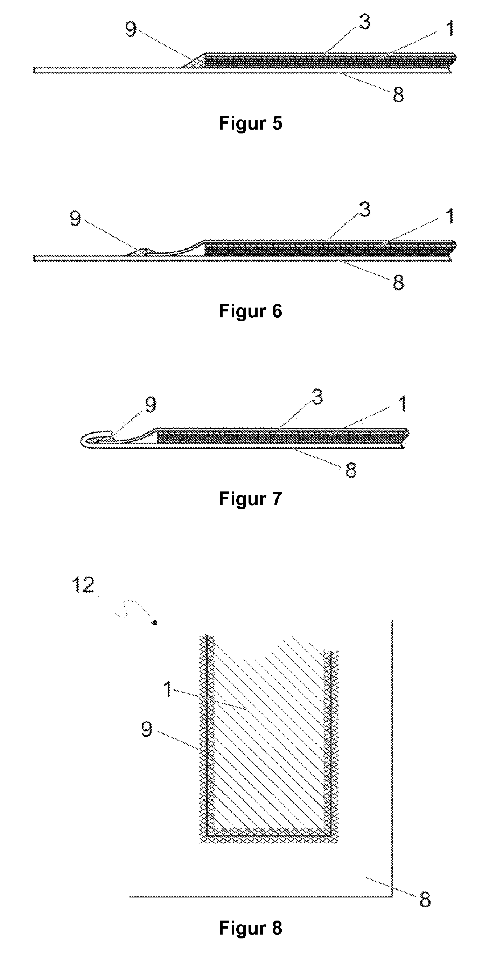

In gewissen Fällen ist es auch möglich und kann sogar von Vorteil sein, dass die Dichtmasse 9, wie in Figur 5 dargestellt, nur die Schnittkante des Photovoltaik-Laminats 1 und einen Teil des Trägers 8 erfasst. Da die Haftfläche der Dichtmasse in diesem Fall auf die Schnittfläche des Photovoltaik-Laminats 1 bzw. der Oberschicht 3 beschränkt ist, sollte die Vorbehandlung des Randbereichs des Photovoltaik-Laminats so ausgerichtet sein, dass sie auch den Bereich der Schnittkante erfasst.

Weiterhin ist es möglich, dass die Oberschicht 3 des Photovoltaik-Laminats 1 verlängert ausgebildet ist und dass die Dichtmasse 9, wie in Figur 6 dargestellt, den Randbereich der Oberschicht 3 und den Träger 8 erfasst.

Ebenfalls denkbar ist es in diesem Fall, dass der Träger 8 über den Randbereich des Photovoltaik-Laminats bzw. über den Randbereich der Oberschicht 3 gefaltet wird und dass die Dichtmasse 9 dann im entstanden Bördelfalz appliziert wird. Diese Ausführungsform ist in Figur 7 gezeigt.

Bei der Dichtmasse handelt es sich vorzugsweise um eine Siliconzusammensetzung oder um eine Zusammensetzung auf der Basis von silanterminierten Poly(meth)acrylaten.

Als Siliconzusammensetzung eignen sich ein- oder zweikomponentige, feuchtigkeitshärtende Siliconzusammensetzungen wie sie häufig im Fenster- oder Fassadenbau eingesetzt werden. Beispielsweise sind derartige Siliconzusammensetzungen unter der Bezeichnung Sikasil^{®} kommerziell erhältlich von der Sika Schweiz AG.

Als einkomponentige, feuchtigkeitshärtende Siliconzusammensetzungen eignen sich beispielsweise Zusammensetzungen auf Basis von Alkoxy-, Acetoxy- oder Ketoximgruppen terminierten Polydiorganosiloxanen umfassend weitere Bestandteile, wie sie nachfolgend als "weitere Bestandteile" in der Komponente **A** in den zweikomponentigen Siliconzusammensetzungen beschrieben sind sowie geeignete Vernetzer und Katalysatoren.

Beispielsweise sind geeignete einkomponentige, feuchtigkeitshärtende Siliconzusammensetzungen, als Komponente **A** in der europäischen Patentanmeldung mit der Anmeldenummer 08172783.6 beschrieben, deren gesamte Offenbarung hiermit durch Bezugnahme eingeschlossen ist.

Bevorzugte einkomponentige, feuchtigkeitshärtende Siliconzusammensetzungen, sind beispielsweise beschrieben in der Patentanmeldung WO 2008/025812 A1, deren gesamte Offenbarung hiermit durch Bezugnahme eingeschlossen ist.

Weiterhin sind geeignete einkomponentige, feuchtigkeitshärtende Siliconzusammensetzungen beispielsweise unter den Handelsnamen Sikasil^{®} AS-70, WS-605 S, WS-305 oder SG-20 kommerziell erhältlich von Sika Schweiz AG.

Weiterhin geeignet sind einkomponentige, feuchtigkeitshärtende Siliconzusammensetzungen wie sie vorhergehend erwähnt worden sind, welche bei der Applikation mit einer Wasser enthaltenden Komponente in Verbindung gebracht werden.

Typischerweise weist die Wasser enthaltende Komponente neben Wasser mindestens ein Trägermaterial auf, welches ausgewählt ist aus der Gruppe bestehend aus einem Polydiorganosiloxan, einem Weichmacher, einem Verdickungsmittel und einem Füllstoff. Bevorzugt ist das Trägermaterial von der Art, dass es verdickend wirkt und Wasser bindet.

Der Wassergehalt in der Wasser enthaltenden Komponente liegt insbesondere in dem Bereich, dass mit dem vorhandenen Wasser 50 bis 100 % aller reaktiven Gruppen in der Zusammensetzung umgesetzt werden können.

Bei der Applikation derartiger Zusammensetzungen wird die einkomponentige, feuchtigkeitshärtende Siliconzusammensetzung beispielsweise durch Rühren, Kneten Walzen oder dergleichen, insbesondere jedoch über einen Statikmischer oder über einen dynamischen Mischer, mit der Wasser enthaltenden Komponente vermischt, wobei die einkomponentige, feuchtigkeitshärtende Siliconzusammensetzung, in Kontakt mit dem Wasser kommt, was zu einer Vernetzung der Zusammensetzung führt.

Derartige Siliconzusammensetzungen sowie ihre Anwendung sind beispielsweise im Detail beschrieben in der europäischen Patentanmeldung mit der Anmeldenummer 08172783.6, deren gesamte Offenbarung hiermit durch Bezugnahme eingeschlossen ist.

Bevorzugt handelt es sich bei der Dichtmasse um eine zweikomponentige Dichtmasse, insbesondere um eine zweikomponentige Siliconzusammensetzung. Der Vorteil einer zweikomponentigen Dichtmasse ist die schnellere Aushärtung der Zusammensetzung, welche ein schnelleres und somit wirtschaftlicheres Herstellungsverfahren erlaubt.

Meist bevorzugt handelt es sich bei der Dichtmasse um eine zweikomponentige Siliconzusammensetzung.

Als zweikomponentige Siliconzusammensetzung eignen sich insbesondere Siliconzusammensetzungen bestehend aus einer Komponente **A** und einer Komponente **B.**

Die Komponente **A** umfasst dabei ein Hydroxylgruppen terminiertes Polydiorganosiloxan, insbesondere ein Polydiorganosiloxan **P** der Formel (I).

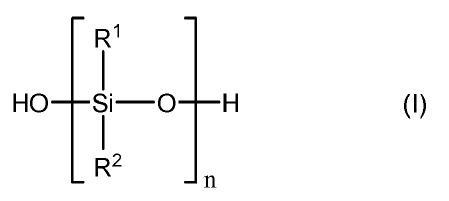

Dabei stehen die Reste R¹ und R² unabhängig voneinander für lineare oder verzweigte, einwertige Kohlenwasserstoffreste mit 1 bis 12 C-Atomen, welche gegebenenfalls ein oder mehrere Heteroatome, und gegebenenfalls eine oder mehrere C-C-Mehrfachbindungen und/oder gegebenenfalls cycloaliphatische und/oder aromatische Anteile aufweisen. Insbesondere stehen die Reste R¹ und R² für Alkylreste mit 1 bis 5, insbesondere mit 1 bis 3, C-Atomen, bevorzugt für Methylgruppen.

Der Index n ist so gewählt, dass das Polydiorganosiloxan **P** bei einer Temperatur von 23 °C eine Viskosität von 10 bis 500'000 mPa·s, insbesondere von 6'000 bis 100'000 mPa·s, aufweist.

Die Komponente **A** der zweikomponentigen Siliconzusammensetzung umfasst typischerweise weitere Bestandteile. Derartige weitere Bestandteile sind insbesondere Weichmacher wie trialkylsilylterminierte Polydialkylsiloxane, insbesondere trimethylsilylterminierte Polydimethylsiloxane, anorganische und/oder organische Füllstoffe wie Calciumcarbonate, calcinierte Kaoline, Russ, hochdisperse Kieselsäuren (v.a. aus Pyrolyseprozessen) sowie flammhemmende Füllstoffe, wie Hydroxide oder Hydrate, insbesondere Hydroxide oder Hydrate von Aluminium, bevorzugt Aluminiumhydroxid, Härtungsbeschleuniger, Pigmente, Haftvermittler, wie Organoalkoxysilane, deren organische Reste vorzugsweise mit funktionellen Gruppen substituiert sind, Verarbeitungshilfsmittel, Rheologiemodifikatoren, Stabilisatoren, Farbstoffe, Inhibitoren, Hitzestabilisatoren, Antistatika, Flammschutzmittel, Biozide, Wachse, Verlaufsmittel, Thixotropierungsmittel und weitere dem Fachmann bekannte gängige Rohstoffe und Additive.

Die Komponente **B** der zweikomponentigen Siliconzusammensetzung umfasst im Wesentlichen mindestens einen Vernetzer für Polydiorganosiloxane sowie mindestens einen Katalysator **K** für die Vernetzung von Polydiorganosiloxanen.

Insbesondere handelt es sich beim Katalysator **K** um eine zinnorganische Verbindung oder um ein Titanat.

Bevorzugte zinnorganische Verbindungen sind Dialkylzinnverbindungen wie sie beispielsweise ausgewählt sind aus der Gruppe bestehend aus Dimethylzinndi-2-ethylhexanoat, Dimethylzinndilaurat, Di-n-butylzinndiacetat, Di-n-butylzinndi-2-ethylhexanoat, Di-n-butylzinndicaprylat, Di-n-butylzinndi-2,2-dimethyloctanoat, Di-n-butylzinndilaurat, Di-n-butylzinn-distearat, Di-n-butylzinndimaleinat, Di-n-butylzinndioleat, Di-n-butylzinndiacetat, Di-n-octylzinndi-2-ethylhexanoat, Di-n-octylzinndi-2,2-dimethyloctanoat, Di-n-octylzinndimaleinat und Di-n-octylzinndilaurat.

Als Titanate bzw. Organotitanate werden Verbindungen bezeichnet, welche mindestens einen über ein Sauerstoffatom an das Titanatom gebundenen Liganden aufweisen. Als über eine Sauerstoff-Titan-Bindung an das Titanatom gebundene Liganden eignen sich dabei diejenigen, welche ausgewählt sind aus der Gruppe bestehend aus Alkoxygruppe, Sulfonatgruppe, Carboxylatgruppe, Dialkylphosphatgruppe, Dialkylpyrophosphatgruppe und Acetylacetonatgruppe. Bevorzugte Titanate sind beispielsweise Tetrabutyl- oder Tetraisopropyltitanat.

Weiterhin geeignete Titanate weisen mindestens einen mehrzähnigen Liganden, auch Chelatligand genannt, auf. Insbesondere ist der mehrzähnige Ligand ein zweizähniger Ligand.

Geeignete Titanate sind beispielsweise unter den Handelsnamen Tyzor^{®} AA, GBA, GBO, AA-75, AA-65, AA-105, DC, BEAT, IBAY kommerziell erhältlich von der Firma DuPont, USA.

Selbstverständlich ist es möglich oder in gewissen Fällen sogar bevorzugt, Mischungen verschiedener Katalysatoren einzusetzen.

Als Vernetzer für Polydiorganosiloxane enthält die Komponente **B** der zweikomponentigen Siliconzusammensetzung insbesondere ein Silan der Formel (II).

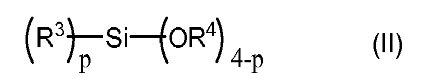

Der Rest R³ steht dabei unabhängig voneinander für einen linearen oder verzweigten, einwertigen Kohlenwasserstoffrest mit 1 bis 12 C-Atomen, welcher gegebenenfalls ein oder mehrere Heteroatome, und gegebenenfalls eine oder mehrere C-C-Mehrfachbindungen und/oder gegebenenfalls cycloaliphatische und/oder aromatische Anteile aufweist.

Der Rest R⁴ steht unabhängig voneinander für ein Wasserstoffatom, oder für einen Alkylrest mit 1 bis 12 C-Atomen, oder für einen Carbonylrest mit 1 bis 12 C-Atomen, oder für einen Oximrest mit 1 bis 12 C-Atomen. Insbesondere steht der der Rest R⁴ für einen Alkylrest mit 1 bis 5, insbesondere 1 bis 3, C-Atomen, bevorzugt für eine Methyl- oder für eine Ethylgruppe.

Der Index p steht für einen Wert von 0 bis 4, mit der Massgabe, dass falls p für einen Wert von 3 oder 4 steht, mindestens p-2 Reste R³ jeweils mindestens eine mit den Hydroxylgruppen des Polydiorganosiloxans **P** reaktive, insbesondere kondensierbare, Gruppe, also beispielsweise eine Hydroxylgruppe aufweisen. Insbesondere steht p für einen Wert von 0, 1 oder 2, bevorzugt für einen Wert von 0.

Beispiele geeigneter Silane der Formel (II) sind Methyltrimethoxysilan, Chlormethyltrimethoxysilan, Ethyltrimethoxysilan, Propyltrimethoxysilan, Vinyltrimethoxysilan, Methyltriethoxysilan, Vinyltriethoxysilan, Phenyltriethoxysilan, Methyltripropoxysilan, Phenyltripropoxysilan, Tetramethoxysilan, Tetraethoxysilan, Tetra-n-propoxysilan oder Tetra-n-butoxysilan. Besonders bevorzugt handelt es sich beim Silan der Formel (II) um Vinyltrimethoxysilan oder Tetraethoxysilan oder deren Mischung.

Selbstverständlich kann als Vernetzer für die zweikomponentige Siliconzusammensetzung auch eine beliebige Mischung der vorhergehend genannten Silane eingesetzt werden.

In einer grosstechnischen Anlage werden die beiden Komponenten **A** und **B** typischerweise in Fässern oder Hobbocks voneinander getrennt aufbewahrt und bei der Applikation, beispielsweise mittels Zahnradpumpen, ausgepresst und wie vorhergehend beschrieben vermischt.

Bevorzugte zweikomponentige Siliconzusammensetzungen, sind beispielsweise im Detail beschrieben in der europäischen Patentanmeldung mit der Anmeldenummer 08169676.7, deren gesamte Offenbarung hiermit durch Bezugnahme eingeschlossen ist.

Weiterhin sind geeignete zweikomponentige Siliconzusammensetzungen unter den Handelsnamen Sikasil^{®} AS, beispielsweise Sikasil^{®} AS-785, oder unter de Handelsnamen Sikasil^{®} WT, beispielsweise Sikasil^{®} WT 485, kommerziell erhältlich von Sika Schweiz AG.

Weiterhin geeignete Siliconzusammensetzungen sind solche, wie sie allgemein auch als Silikonkautschuk bekannt sind. Beispielsweise ist ein derartiger Silikonkautschuk eine zweikomponentige Siliconzusammensetzung bestehend aus einer Komponente **A** umfassend ein Polydiorganosiloxan mit ungesättigten organischen Resten, insbesondere Vinylgruppen, und einer Komponente **B** umfassend ein Silan mit Si-H-Bindungen. Als Katalysator für die Additionsvernetzung eines derartigen Siliconkautschuks dienen typischerweise Platin-, Palladium- oder Rhodiumverbindungen.

Ebenfalls denkbar ist der Einsatz eines radikalisch härtenden, Polydiorganosiloxans, welches ebenfalls ungesättigte organische Reste, insbesondere Vinylgruppen, aufweist. Als Radikalbildner eignen sich dabei beispielsweise Peroxide, Perester und dergleichen. Radikalisch härtende Siliconzusammensetzungen können einkomponentig oder zweikomponentig ausgebildet sein. Beispielsweise weisen derartige einkomponentige Siliconzusammensetzungen Radikalbildner auf, welche unter Einfluss von Wärme oder von elektromagnetischer Strahlung, insbesondere UV-Strahlung, Radikale bilden. Bei den zweikomponentigen, radikalisch härtenden Siliconzusammensetzungen, erfolgt die Radikalbildung typischerweise mittels Katalysator, welcher in der Komponente **B** vorliegt

Als Zusammensetzung auf der Basis von silanterminierten Poly(meth)-acrylaten eignen sich Zusammensetzungen umfassend mindestens ein silanterminiertes Poly(meth)acrylat, welches insbesondere erhältlich ist durch eine Hydrosilylierungsreaktion von Poly(meth)acrylaten mit endständigen Doppelbindungen. Dieses Herstellungsverfahren ist beispielsweise beschrieben in US 3,971,751 und US 6,207,766, deren Offenbarung hiermit durch Bezugnahme eingeschlossen ist.

Beispielsweise sind geeignete silanterminierte Poly(meth)acrylate unter dem Handelsnamen Kaneka XMAP™ kommerziell erhältlich von Kaneka Corporation, Japan.

Geeignete Zusammensetzungen auf der Basis von silanterminierten Poly(meth)acrylaten können ein- oder zweikomponentig ausgebildet sein.

Als zweikomponentige Zusammensetzungen auf der Basis von silanterminierten Poly(meth)acrylaten eignen sich typischerweise einkomponentige, feuchtigkeitshärtende Zusammensetzungen auf der Basis von silanterminierten Poly(meth)acrylaten, welche, wie bereits bei den Siliconzusammensetzungen beschrieben, bei der Applikation mit einer Wasser enthaltenden Komponente in Verbindung gebracht werden.

Bevorzugte Zusammensetzungen auf der Basis von silanterminierten Poly(meth)acrylaten, sind beispielsweise von der Art und Beschaffenheit, wie sie im Detail beschrieben sind in der europäischen Patentanmeldung mit der Anmeldenummer 09161265.5, deren gesamte Offenbarung hiermit durch Bezugnahme eingeschlossen ist.

Weiterhin betrifft die vorliegende Erfindung ein Photovoltaik-Modul.

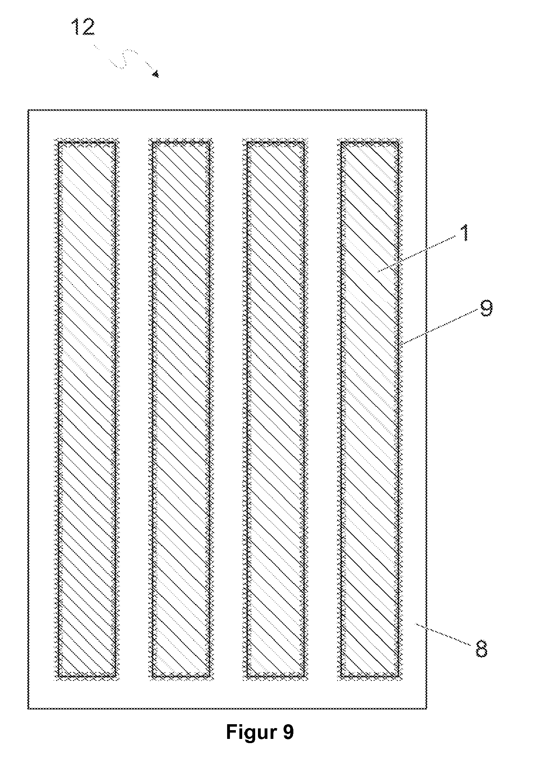

Wie in den Figuren 8 und 9 dargestellt, weist das Photovoltaik-Modul 12 dabei einen Träger 8 auf, an welchem ein Photovoltaik-Laminat 1 angebracht ist, wobei die Stelle des Randbereichs des Photovoltaik-Laminats mit einer Dichtmasse 9 abgedichtet ist und diese Dichtmasse eine Siliconzusammensetzung oder eine Zusammensetzung auf der Basis von silanterminierten Poly(meth)acrylaten ist. Der Träger, das Photovoltaik-Laminat und die Dichtmasse sind dabei von der Art, wie sie vorhergehend bereits beschrieben worden ist.

Insbesondere handelt es sich dabei um ein Photovoltaik-Modul, wie es aus dem vorhergehend beschriebenen Verfahren erhältlich ist.

Weiterhin betrifft die vorliegende Erfindung die Verwendung einer Siliconzusammensetzung oder einer Zusammensetzung auf der Basis von silanterminierten Poly(meth)acrylaten zur Randversiegelung von Photovoltaik-Modulen. Insbesondere handelt es sich bei der verwendeten Zusammensetzung um eine, wie sie vorhergehend bereits beschrieben worden ist. Die Verwendung derartiger Zusammensetzungen zur Randversiegelung von Photovoltaik-Modulen weist den Vorteil auf, dass diese Zusammensetzungen eine sehr hohe UV-Stabilität aufweisen.

Bevorzugt ist die Verwendung einer Siliconzusammensetzung, wobei diese eine zweikomponentige Siliconzusammensetzung ist.

### Beispiele

Im Folgenden sind Ausführungsbeispiele aufgeführt, welche die beschriebene Erfindung näher erläutern sollen. Selbstverständlich ist die Erfindung nicht auf diese beschriebenen Ausführungsbeispiele beschränkt.

Es wurde die Haftung einer zweikomponentigen Siliconzusammensetzung auf der Oberfläche eines Photovoltaik-Laminats getestet. Dazu wurde in einem ersten Schritt ein Photovoltaik-Laminat mit einer Oberfläche aus ETFE, wie es kommerziell erhältlich ist von der Firma United Solar Ovonic LLC, USA, (ETFE: Tefzel^{®} ETFE von DuPont, USA) mit einem Plasma vorbehandelt. Das Plasma wurde dabei mit einer Anlage FG 3001 von Plasmatreat GmbH, Deutschland, (2 bar Luftdruck, 260 V, 2,8 A) erzeugt und durch eine Düse aus einer Distanz von 8 mm appliziert. Das Photovoltaik-Laminat wurde mit einer Geschwindigkeit von etwa 150 mm/Sekunde vorgeschoben.

Nach der Plasmavorbehandlung wurde auf die vorbehandelte Stelle jeweils eine Raupe einer zweikomponentigen Siliconzusammensetzung Sikasil^{®} WT 485, kommerziell erhältlich bei der Sika Schweiz AG, mittels Applikationsanlage von der Firma Dosiplast, Schweiz, durch einen Statikmischer appliziert.

An den aufgetragenen Raupen wurde nach 15 Minuten bei 23 °C und 50 % relativer Luftfeuchtigkeit eine Haftung von 100 % festgestellt (100 % Kohäsionsbruch).

Nach dieser Prüfung wurden die Probekörper während 6 Wochen bei 85 °C und 85 % relativer Luftfeuchtigkeit gelagert und zeigten dabei keine optische Veränderung und keine Veränderung in der Haftung (100 % Kohäsionsbruch).

Nach den beschriebenen Prüfungen wurden die Probekörper während 15 Wochen in einer 5 %-igen NaCI-Lösung bei 70 °C gelagert. Auch nach dieser Prüfung zeigten die Probekörper keine optische Veränderung und keine Veränderung in der Haftung (100 % Kohäsionsbruch).

### Bezugszeichenliste

- 1: Photovoltaik-Laminat
- 2: Schicht mit photovoltaischen Zellen
- 3: Oberschicht
- 4: Schicht aus EVA
- 5: Schicht aus PE
- 6: Schicht aus PET
- 7: Substrat für die photovoltaische Beschichtung
- 8: Träger
- 9: Dichtmasse
- 10: Plasma-Strahl
- 11: Abstand
- 12: Photovoltaik-Modul

## Patentansprüche

1. Verfahren zur Randversiegelung von Photovoltaik-Modulen umfassend die Schritte
i) Bereitstellen eines Photovoltaik-Moduls (12) durch Anbringen mindestens eines Photovoltaik-Laminats (1) auf einen Träger (8);
ii) Vorbehandeln des in Schritt i) hergestellten Photovoltaik-Moduls entlang des Randbereichs des Photovoltaik-Laminats mit einer Plasmavorbehandlung oder mit Beflammung mittels Gasflamme, sodass sowohl der Randbereich des Photovoltaik-Laminats als auch, zumindest teilweise, der Träger von der Plasmavorbehandlung bzw. von der Beflammung erfasst werden;
iii) Applikation einer Dichtmasse (9) zumindest teilweise auf die vorbehandelte Stelle, wobei die Dichtmasse eine Siliconzusammensetzung oder eine Zusammensetzung auf der Basis von silanterminierten Poly(meth)acrylaten ist.

2. Verfahren gemäss Anspruch 1, **dadurch gekennzeichnet, dass** das Photovoltaik-Laminat ein flexibles Photovoltaik-Laminat ist.

3. Verfahren gemäss einem der vorhergehenden Ansprüche, **dadurch gekennzeichnet, dass** das Photovoltaik-Laminat eine Oberschicht aus einem zumindest teilweise halogenierten Polymer aufweist.

4. Verfahren gemäss Anspruch 3, **dadurch gekennzeichnet, dass** das halogenierte Polymer Ethylen-Tetrafluorethylen (ETFE) ist.

5. Verfahren gemäss einem der vorhergehenden Ansprüche, **dadurch gekennzeichnet, dass** der Träger ein flexibler Träger ist.

6. Verfahren gemäss einem der vorhergehenden Ansprüche, **dadurch gekennzeichnet, dass** der Träger eine Membran, insbesondere eine Kunststoff-Dichtungsbahn, ist.

7. Verfahren gemäss einem der vorhergehenden Ansprüche, **dadurch gekennzeichnet, dass** der Träger ein Polyolefin-Träger oder ein Polyvinylchlorid-Träger ist.

8. Verfahren gemäss einem der vorhergehenden Ansprüche, **dadurch gekennzeichnet, dass** die Dichtmasse eine zweikomponentige Siliconzusammensetzung ist.

9. Verfahren gemäss einem der vorhergehenden Ansprüche, **dadurch gekennzeichnet, dass** das Vorbehandeln mit einer Plasmavorbehandlung erfolgt.

10. Verfahren gemäss Anspruch 9, **dadurch gekennzeichnet, dass**, die Plasmavorbehandlung eine Luftplasmabehandlung bei Atmosphärendruck ist.

11. Verfahren gemäss einem der vorhergehenden Ansprüche, **dadurch gekennzeichnet, dass** das Photovoltaik-Laminat auf den Träger geklebt wird.

12. Photovoltaik-Modul (12) umfassend ein Träger (8), an welchem ein Photovoltaik-Laminat (1) angebracht ist, wobei die Stelle des Randbereichs des Photovoltaik-Laminats mit einer Dichtmasse (9) abgedichtet ist und die Dichtmasse eine Siliconzusammensetzung oder eine Zusammensetzung auf der Basis von silanterminierten Poly(meth)acrylaten ist.

13. Photovoltaik-Modul gemäss Anspruch 12 erhältlich aus einem Verfahren gemäss einem der Ansprüche 1 bis 11.

14. Verwendung einer Siliconzusammensetzung oder einer Zusammensetzung auf der Basis von silanterminierten Poly(meth)acrylaten zur Randversiegelung von Photovoltaik-Modulen.

15. Verwendung gemäss Anspruch 14, **dadurch gekennzeichnet, dass** die Siliconzusammensetzung eine zweikomponentige Siliconzusammensetzung ist.
